(19) **Europäisches Patentamt / European Patent Office / Office européen des brevets**

(11) **EP 3 028 384 B1**

(12) **FASCICULE DE BREVET EUROPEEN**

(45) Date de publication et mention
de la délivrance du brevet:
**20.12.2017 Bulletin 2017/51**

(21) Numéro de dépôt: **14747906.7**

(22) Date de dépôt: **31.07.2014**

(51) Int Cl.:
***H03K 17/00* (2006.01)** ***H03K 17/0812* (2006.01)**

(86) Numéro de dépôt international:
**PCT/EP2014/066460**

(87) Numéro de publication internationale:
**WO 2015/014924 (05.02.2015 Gazette 2015/05)**

(54) **DISPOSITIF DE PROTECTION D'AU MOINS UN COMPOSANT ACTIF D'UN MODULE ÉLECTRONIQUE**

VORRICHTUNG ZUM SCHUTZ MINDESTENS EINER AKTIVEN KOMPONENTE EINES ELEKTRONISCHEN MODULS

DEVICE FOR PROTECTING AT LEAST ONE ACTIVE COMPONENT OF AN ELECTRONIC MODULE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.08.2013 FR 1301852**

(43) Date de publication de la demande:
**08.06.2016 Bulletin 2016/23**

(73) Titulaire: **THALES**
**92200 Neuilly sur Seine (FR)**

(72) Inventeurs:
• **FOURMONT, Jean-François**
**F-78851 Elancourt (FR)**
• **HERAULT, Joël, Bernard, François**
**F-78851 Elancourt (FR)**
• **POUDEROUS, Emile, Jean**
**F-78851 Elancourt (FR)**

(74) Mandataire: **Lavoix**
**2, place d'Estienne d'Orves**
**75441 Paris Cedex 09 (FR)**

(56) Documents cités:
**DE-B3-102006 006 541      US-A- 5 479 119**

EP 3 028 384 B1

**Description**

La présente invention concerne un dispositif de protection d'au moins un composant actif d'un module électronique, apte à recevoir un signal électromagnétique hyperfréquence d'entrée et à fournir un signal électromagnétique hyperfréquence audit au moins un composant actif.

Elle concerne également un système électronique incluant un tel dispositif de protection.

L'invention se situe dans le domaine de l'amplification des signaux électromagnétiques hyperfréquence, ayant une fréquence associée supérieure à 0,1GAZ.

De tels signaux sont largement utilisés, notamment dans des applications de télécommunications et dans les radars pour diverses applications, civiles ou militaires.

En particulier, il existe divers systèmes électroniques incluant des composants actifs, permettant d'augmenter la puissance d'un signal électromagnétique en fonctionnement linéaire. Lorsqu'un composant actif fonctionne en saturation, la puissance de sortie d'un signal électromagnétique est quasi constante, quelque soit sa puissance d'entrée. Un taux de compression est associé au rapport de puissance entre la puissance d'entrée et la puissance de sortie. Selon les spécifications d'un tel composant, un taux de compression supérieur à un niveau de seuil prédéterminé peut amener à la destruction du composant. Il est donc nécessaire de contrôler le taux de compression de tels composants actifs. Un exemple de système de protection de surtension d'un circuit électronique est divulgué dans le document US 5 479 119 A. La problématique décrite ci-dessus intervient notamment dans le domaine des radars à antennes actives, comportant un grand nombre de sources actives en parallèle, pour lesquelles il est nécessaire de contrôler le taux de compression.

Afin de limiter le taux de compression dans les radars à antennes actives, on connaît des systèmes de contrôle de niveau de puissance émis utilisant un calcul logiciel. Cependant, de tels systèmes supposent que le niveau du signal hyperfréquence est stable dans le temps, ce qui n'est pas toujours vérifié en pratique.

Afin de pallier aux inconvénients de l'art antérieur, l'invention propose, selon un premier aspect, un dispositif de protection du type précité, qui comporte un module de retard apte à appliquer un temps de retard prédéterminé au signal électromagnétique hyperfréquence d'entrée, branché en parallèle d'un dispositif de déclenchement de commutation apte à comparer un niveau de puissance du signal électromagnétique hyperfréquence d'entrée à un seuil de puissance et à commander une commutation d'un commutateur branché en sortie du module de retard, une sortie dudit commutateur fournissant le signal électromagnétique hyperfréquence en entrée dudit au moins un composant actif, le temps de retard prédéterminé étant tel que la commutation est effectuée avant l'arrivée du signal électromagnétique hyperfréquence en sortie du module de retard.

Avantageusement, le dispositif de l'invention permet de contrôler le niveau de puissance du signal électromagnétique d'entrée et d'actionner le déclenchement du commutateur en fonction du niveau du signal électromagnétique d'entrée. Ainsi, lorsque le dispositif de protection selon l'invention est branché en amont d'au moins un composant électronique actif, un signal électromagnétique hyperfréquence n'est envoyé vers un tel composant que si son niveau de puissance est inférieur à un seuil de puissance prédéterminé, et ce, quelque soit la durée du signal électromagnétique hyperfréquence.

De plus, avantageusement, le dispositif de protection proposé permet de conserver l'intégrité de la forme d'onde du signal électromagnétique hyperfréquence transmis.

Le dispositif selon l'invention peut présenter une ou plusieurs des caractéristiques ci-dessous, prises indépendamment ou en combinaison :

- le module de retard comprend une ligne à retard coaxiale inductive de longueur calculée en fonction du temps de retard prédéterminé ;
- la longueur de la ligne à retard est calculée pour assurer un temps de retard supérieur au temps compris entre le déclenchement de la commutation par le dispositif de déclenchement de commutation et le changement de position du commutateur ;
- la longueur X de la ligne est associée au temps de retard Tr par la formule :

$$X = v \cdot T_r$$

où $v = \dfrac{c}{\sqrt{\varepsilon_r}}$ où c est la vitesse de la lumière et $\varepsilon_r$ est la permittivité de la ligne à retard ;

- le module de retard comprend, en sortie de la ligne à retard, un amplificateur apte à compenser une perte de puissance induite par ladite ligne à retard ;
- le dispositif de déclenchement de commutation comprend un mesureur de puissance et un comparateur de niveau, ledit comparateur étant apte à comparer un niveau de sortie dudit mesureur à un seuil de niveau ;
- le seuil de niveau est fourni par un dispositif externe ;
- il comporte une première sortie et une deuxième sortie, et le niveau de sortie du mesureur comparé au seuil de niveau détermine la position du commutateur entre une première position permettant d'acheminer le signal électromagnétique sortant du module de retard vers ladite première sortie et une deuxième position permettant d'acheminer le signal électromagnétique sortant du module de retard vers ladite deuxième sortie ;
- ledit signal électromagnétique hyperfréquence a une fréquence comprise entre 0,1 GHZ et 40GHz.

Selon un deuxième aspect, l'invention propose un système électronique d'amplification de signaux électromagnétiques hyperfréquence comportant un émetteur de signal électromagnétique hyperfréquence, un système d'amplification branché en sortie de l'émetteur et un module à composants actifs branché en sortie du système d'amplification. Le système selon l'invention comporte un dispositif de protection tel que brièvement décrit ci-dessus branché en série entre le système d'amplification et le module à composants actifs.

D'autres caractéristiques et avantages de l'invention ressortiront de la description qui en est donnée ci-dessous, à titre indicatif et nullement limitatif, en référence aux figures annexées, parmi lesquelles :

- la figure 1 est un exemple schématique d'un système électronique comportant un dispositif selon l'invention, et
- la figure 2 est une représentation schématique d'un dispositif selon l'invention.

L'invention sera décrite plus particulièrement dans son application dans un système de radar à antennes actives.

Il est bien entendu que l'invention ne se limite pas à cette application, et s'applique dans tout système électronique nécessitant un contrôle de puissance d'un signal électromagnétique hyperfréquence, notamment pour la protection de composants actifs.

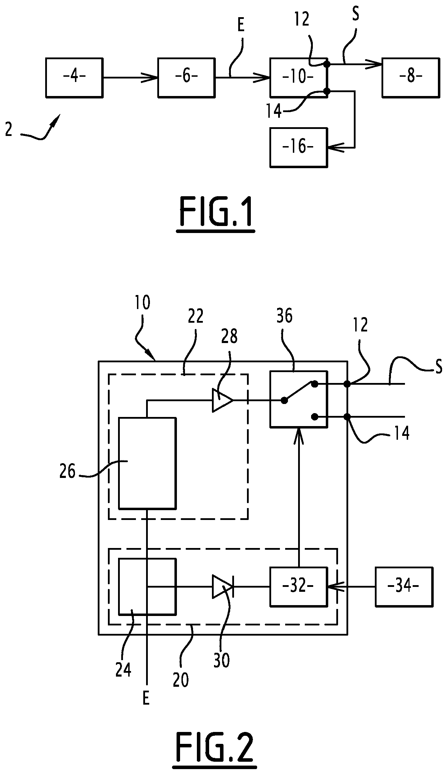

La figure 1 illustre schématiquement un système électronique 2, comportant un émetteur 4 de signal électromagnétique hyperfréquence dans la bande de fréquence 8GHZ à 12GHz. Plus généralement, l'invention s'applique avec pour tout signal électromagnétique hyperfréquence de fréquence comprise entre 0,1GHz et 40GHz. L'émetteur 4 est branché en entrée d'un système amplificateur 6, apte à amplifier un signal électromagnétique hyperfréquence reçu en entrée. Le système d'amplification 6 est classiquement connecté à un module électronique 8 comportant un ou plusieurs composants actifs.

Dans cet exemple de réalisation, le module 8 comporte plusieurs composants actifs dont des amplificateurs de signaux hyperfréquence, branchés en parallèle, aptes à fonctionner en saturation selon une spécification associée fournie par le fabricant de ces composants actifs.

Comme déjà expliqué ci-dessus, afin d'assurer un bon fonctionnement du système électronique 2, il est utile de maîtriser le taux de compression de fonctionnement des composants actifs du module 8, en fonction de la spécification fournie, afin d'assurer un bon rendement et un fonctionnement sans risque d'endommagement.

A cet effet, l'invention propose un dispositif de protection 10 apte à contrôler le niveau de puissance du signal électromagnétique hyperfréquence S fourni en entrée du module 8.

Un tel dispositif de protection 10 sera décrit plus en détail ci-après en référence à la figure 2.

Le dispositif de protection 10 reçoit en entrée un signal électromagnétique hyperfréquence E, en provenance du système amplificateur 6.

Le dispositif de protection 10 comporte deux sorties signal, une première sortie 12 branchée en entrée du module 8 et une deuxième sortie 14 branchée à une charge 16.

Le signal électromagnétique hyperfréquence E, dit signal d'entrée, est acheminé vers la première sortie 12 si sa puissance est inférieure à un seuil de puissance prédéterminé et vers la deuxième sortie 14 si sa puissance est supérieure à ce seuil de puissance prédéterminé.

Avantageusement, le dispositif de protection 10 permet de préserver l'intégrité de la forme d'onde du signal électromagnétique hyperfréquence E, et donc la forme d'onde du signal électromagnétique de sortie du dispositif de protection 10 est la même que celle du signal d'entrée E dans le cas d'un fonctionnement en linéaire.

Comme illustré à la figure 2, le dispositif de protection 10 de puissance comporte un dispositif de déclenchement de commutation 20 et un module de retard 22, montés en parallèle.

Le signal électromagnétique hyperfréquence d'entrée E est acheminé en entrée du module de retard 22 via un coupleur 24, vers une ligne à retard inductive 26.

Le module de retard 22 comprend également un amplificateur 28 apte à compenser les pertes de puissance du signal électromagnétique hyperfréquence acheminé dues à la ligne à retard 26.

Le dispositif de déclenchement de commutation 20 comporte un mesureur de niveau 30, par exemple une diode ou un détecteur logarithmique, branché sur la voie couplée issue du coupleur 24. Le niveau Vd en sortie du mesureur de niveau 30 est comparé en permanence à un seuil prédéterminé, qui est un seuil de niveau Vs dans ce mode de réalisation, à l'aide d'un comparateur 32.

Le seuil de niveau est fourni par exemple par un dispositif convertisseur numérique analogique 34, qui est un dispositif programmable externe au dispositif de protection 10 et programmable par un utilisateur.

Alternativement, d'autres moyens permettant d'introduire un seuil de niveau Vs, par exemple par un autre type de dispositif externe non programmable, sont utilisables.

Lorsque le niveau Vd détecté est supérieur au seuil de niveau Vs, le comparateur 32 change d'état, ce qui active un changement de position d'un commutateur 36, branché en sortie du module de retard 22.

Ainsi, lorsque le niveau Vd détecté est supérieur au seuil de niveau Vs, l'entrée du commutateur 36 issue du module de retard 22 est branchée sur la deuxième sortie 14 du dispositif de protection 10. Lorsque le niveau Vd détecté est inférieur au seuil de niveau Vs, l'entrée du commutateur 36 issue du module de retard 22 est branchée sur la première sortie 12 du dispositif de protection 10.

En d'autres termes, le signal électromagnétique issu du module de retard 22 est acheminé sur la première sortie du dispositif de protection 10 uniquement lorsque son niveau détecté Vd est inférieur au seuil de niveau prédéterminé Vs.

La longueur de la ligne à retard 26 est déterminée de manière à assurer que cette ligne à retard fournit un temps de retard prédéterminé Tr supérieur au temps compris entre le déclenchement de la commutation par le dispositif de déclenchement de commutation 20 et le changement de position du commutateur 36.

Ainsi, le module de retard 22 introduit un retard suffisant pour que la commutation du commutateur 36 soit déclenchée systématiquement, le cas échéant, c'est-à-dire quand Vd est supérieur à Vs, avant l'arrivée du signal électromagnétique en entrée du commutateur 36.

Avantageusement, le temps de retard Tr est ajusté de manière à limiter la longueur de la ligne à retard 26, tout en assurant la fonction de commutation décrite ci-dessus, permettant ainsi également de limiter la perte de puissance introduite par la ligne à retard 26, ainsi que la masse et le volume du dispositif de protection 10.

Pour une ligne à retard inductive, la longueur X de la ligne est associée au temps de retard Tr par la formule :

$$X = v \cdot T_r$$

où $v = \dfrac{c}{\sqrt{\varepsilon_r}}$ où c est la vitesse de la lumière et $\varepsilon_r$ est la permittivité de la ligne à retard.

Ainsi, la longueur d'une telle ligne à retard est facilement calculable à partir du temps de retard Tr préalablement déterminé.

Avantageusement, lorsqu'un dispositif de protection 10 tel que décrit est introduit dans un système électronique en amont du branchement d'un ou plusieurs composants actifs, il permet de contrôler le niveau de puissance du signal fourni à ces composants actifs. Ainsi, le taux de compression de ces composants est contrôlé pour un fonctionnement en saturation, ce qui permet d'améliorer le rendement global d'un tel système électronique, de le protéger contre des fluctuations dans le temps du signal électromagnétique hyperfréquence d'entrée et de maîtriser la qualité du signal émis.

En variante à ce qui a été décrit ci-dessus, le dispositif de protection 10 peut être intégré dans un système amplificateur 6.

Le dispositif de protection 10 selon l'invention et le système électronique 2 utilisant un tel dispositif ont été décrits en particulier pour une utilisation avec des signaux électromagnétiques hyperfréquence de la bande de X, ayant une fréquence comprise entre 8 et 12GHz.

Cependant le dispositif de l'invention s'applique avec des signaux électromagnétiques hyperfréquence de fréquence supérieure à 0,1 GHz. Selon la bande de fréquence utilisée, le principe de l'invention s'applique de manière analogue, mais un dispositif selon l'invention peut comporter des composants adéquats différents. Par exemple, la ligne à retard coaxiale inductive peut être remplacée par une ligne à retard optique.

**Revendications**

1. Dispositif de protection (10) d'au moins un composant actif d'un module électronique, apte à recevoir un signal électromagnétique hyperfréquence d'entrée (E) et à fournir un signal électromagnétique hyperfréquence (S) audit au moins un composant actif, **caractérisé en ce qu'**il comporte un module de retard (22) apte à appliquer un temps de retard prédéterminé au signal électromagnétique hyperfréquence d'entrée (E), branché en parallèle d'un dispositif de déclenchement de commutation (20) apte à comparer un niveau de puissance du signal électromagnétique hyperfréquence d'entrée (E) à un seuil de puissance et à commander une commutation d'un commutateur (36) branché en sortie du module de retard, une sortie dudit commutateur fournissant le signal électromagnétique hyperfréquence en entrée dudit au moins un composant actif, le temps de retard prédéterminé étant tel que la commutation est effectuée avant l'arrivée du signal électromagnétique hyperfréquence en sortie du module de retard (22).

2. Dispositif selon la revendication 1, **caractérisé en ce que** le module de retard (22) comprend une ligne à retard coaxiale inductive (26) de longueur calculée en fonction du temps de retard prédéterminé.

3. Dispositif selon la revendication 2, **caractérisé en ce que** la longueur de la ligne à retard est calculée pour assurer un temps de retard supérieur au temps compris entre le déclenchement de la commutation par le dispositif de déclenchement de commutation (20) et le changement de position du commutateur (36).

4. Dispositif selon la revendication 3, **caractérisé en ce que** la longueur X de la ligne est associée au temps de retard Tr par la formule :

$$X = v \cdot T_r$$

où $v = \dfrac{c}{\sqrt{\varepsilon_r}}$ où c est la vitesse de la lumière et $\varepsilon_r$ est la permittivité de la ligne à retard.

**5.** Dispositif selon l'une des revendications 2 à 4, **caractérisé en ce que** le module de retard (22) comprend, en sortie de la ligne à retard, un amplificateur (28) apte à compenser une perte de puissance induite par ladite ligne à retard (26).

**6.** Dispositif selon l'une des revendications 1 à 5, **caractérisé en ce que** le dispositif de déclenchement de commutation (20) comprend un mesureur de puissance (30) et un comparateur (32) de niveau, ledit comparateur étant apte à comparer un niveau de sortie dudit mesureur (30) à un seuil de niveau.

**7.** Dispositif selon la revendication 6, **caractérisé en ce que** le seuil de niveau est fourni par un dispositif externe (34).

**8.** Dispositif selon l'une des revendications 6 ou 7, **caractérisé en ce qu'**il comporte une première sortie (12) et une deuxième sortie (14), et **en ce que** le dispositif de déclenchement de commutation (20) est apte à commander, en fonction de la comparaison effectuée par le comparateur (32) du niveau de sortie du mesureur (30) au seuil de niveau, la position du commutateur (36) entre une première position permettant d'acheminer le signal électromagnétique sortant du module de retard vers ladite première sortie (12) et une deuxième position permettant d'acheminer le signal électromagnétique sortant du module de retard vers ladite deuxième sortie (14).

**9.** Dispositif selon l'une quelconque des revendications précédentes, **caractérisé en ce qu'**il est apte à fournir audit au moins un composant actif un signal électromagnétique hyperfréquence ayant une fréquence comprise entre 0,1GHz et 40GHz.

**10.** Système électronique d'amplification de signaux électromagnétiques hyperfréquence comportant un émetteur (4) de signal électromagnétique hyperfréquence, un système d'amplification (6) branché en sortie de l'émetteur (4) et un module (8) à composants actifs branché en sortie du système d'amplification (6), **caractérisé en ce qu'**il comporte un dispositif de protection (10) selon l'une des revendications 1 à 9 branché en série entre le système d'amplification (6) et le module (8) à composants actifs.

**Patentansprüche**

**1.** Vorrichtung zum Schutz (10) mindestens einer Komponente eines elektronischen Moduls, geeignet zum Empfangen eines elektromagnetischen Mikrowellen-Eingangssignals (E) und zum Bereitstellen eines elektromagnetischen Mikrowellensignals (S) an die mindestens eine aktive Komponente, dadurch charakterisiert, dass sie ein Verzögerungsmodul (22) aufweist, geeignet zum Anwenden einer vorgegebenen Verzögerungszeit auf das elektromagnetische Mikrowellen-Eingangssignal (E), das parallel zu einer Vorrichtung zum Auslösen eines Schaltens (20) geschaltet ist, geeignet zum Vergleichen eines Spannungspegels des elektromagnetischen Mikrowellen-Eingangssignals (E) mit einem Spannungs-Schwellwert und zum Steuern eines Schaltens eines Schalters (36), der an den Ausgang des Verzögerungsmoduls angeschlossen ist, wobei ein Ausgang des Schalters das elektromagnetischen Mikrowellen-Signal am Eingang der mindestens einen aktiven Komponente bereitstellt, wobei die vorgegebene Verzögerungszeit derart ist, dass das Schalten vor der Ankunft des elektromagnetischen Mikrowellen-Signals am Ausgang des Verzögerungsmoduls (22) erfolgt.

**2.** Vorrichtung gemäß Anspruch 1, dadurch charakterisiert, dass das Verzögerungsmodul eine induktive Koaxialverzögerungsleitung (26) mit einer in Abhängigkeit der vorgegebenen Verzögerungszeit berechneten Länge aufweist.

**3.** Vorrichtung gemäß Anspruch 2, dadurch charakterisiert, dass die Länge der Verzögerungsleitung berechnet ist, um eine Verzögerungszeit sicherzustellen, die größer als die Zeit ist, die zwischen dem Auslösen des Schaltens durch die Vorrichtung zum Auslösen eines Schaltens (20) und der Änderung der Position des Schalters (36) liegt.

**4.** Vorrichtung gemäß Anspruch 3, dadurch charakterisiert, dass die Länge X der Leitung mit der Verzögerungszeit zusammenhängt gemäß der Formel:

$$X = v \cdot T_r$$

wobei $V = \dfrac{c}{\sqrt{\varepsilon_r}}$ wobei c die Lichtgeschwindigkeit und $\varepsilon_r$ die Permittivität der Verzögerungsleitung ist.

**5.** Vorrichtung gemäß einem der Ansprüche 2 bis 4, dadurch charakterisiert, dass das Verzögerungsmodul (22) am Ausgang der Verzögerungsleitung einen Verstärker (28) aufweist, der dazu geeignet ist, einen von der Verzögerungsleitung (26) hervorgerufenen Spannungsverlust zu kompensieren.

**6.** Vorrichtung gemäß einem der Ansprüche 1 bis 5, dadurch charakterisiert, dass die Vorrichtung zum Auslösen eines Schaltens (20) einen Spannungsmesser (30) und einen Pegel-Vergleicher (32) aufweist, wobei der Vergleicher dazu geeignet ist, einen Ausgangspegel des Spannungsmessers (30) mit einem Pegel-Schwellwert zu vergleichen.

**7.** Vorrichtung gemäß Anspruch 6, dadurch charakterisiert, dass der Pegel-Schwellwert von einer externen Vorrichtung (34) bereitgestellt wird.

**8.** Vorrichtung gemäß einem der Ansprüche 6 oder 7, dadurch charakterisiert, dass sie einen ersten Ausgang (12) und einen zweiten Ausgang (14) aufweist und dadurch, dass die Vorrichtung zum Auslösen eines Schaltens (20) geeignet ist, abhängig von dem durch den Vergleicher (32) durchgeführten Vergleich des Ausgangspegels des Spannungsmessers (30) mit dem Pegel-Schwellwert die Position des Schalters (36) zwischen einer ersten Position, die es ermöglicht, das aus dem Verzögerungsmodul austretende elektromagnetische Signal in Richtung des ersten Ausgangs (12) zu führen, und einer zweiten Position, die es ermöglicht, das aus dem Verzögerungsmodul austretende elektromagnetische Signal in Richtung des zweiten Ausgangs (14) zu führen, zu steuern.

**9.** Vorrichtung gemäß einem der vorhergehenden Ansprüche, dadurch charakterisiert, dass sie dazu geeignet ist, der mindestens einen aktiven Komponente ein elektromagnetisches Mikrowellensignal bereitzustellen, das eine Frequenz hat, die zwischen 0,1 GHz und 40 GHz liegt.

**10.** Elektronisches System zur Verstärkung von elektromagnetischen Mikrowellensignalen aufweisend einen Elektromagnetisches-Mikrowellensignal-Sender (4), ein Verstärkungssystem (6), das an den Ausgang des Senders (4) angeschlossen ist und ein Modul (8) mit aktiven Komponenten, das an den Ausgang des Verstärkungssystems (6) angeschlossen ist, dadurch charakterisiert, dass es eine Schutzvorrichtung (10) gemäß einem der Ansprüche 1 bis 9 aufweist, die in Serie zwischen das Verstärkungssystem (6) und das Modul (8) mit aktiven Komponenten geschaltet ist.

**Claims**

**1.** A device (10) for protecting at least one active component of an electronic module, able to receive a microwave electromagnetic input signal (E) and to provide a microwave electromagnetic signal (S) to said at least one active component, **characterized in that** it includes a delay module (22) able to apply a predetermined delay time to the microwave electromagnetic input signal (E), connected in parallel with a switch-triggering device (20) able to compare a power level of the microwave electromagnetic input signal (E) to a power threshold and to command switching by a switch (36) connected at the output of the delay module, an output of said switch providing the microwave electromagnetic signal as input to said at least one active component, the predetermined delay time being such that the switching is done before the arrival of the microwave electromagnetic signal at the output of the delay module (22).

**2.** The device according to claim 1, **characterized in that** the delay module (22) comprises a coaxial inductive delay line (26) with a length computed as a function of the predetermined delay time.

**3.** The device according to claim 2, **characterized in that** the length of the delay line is computed to ensure a delay time greater than the time comprised between the triggering of the switching by the switch-triggering device (20) and the position change of the switch (36).

**4.** The device according to claim 3, **characterized in that** the length X of the line is associated with the delay time Tr by the formula:

$$X = v \cdot T_r$$

where $v = \dfrac{c}{\sqrt{\varepsilon_r}}$, where c is the speed of light and $\varepsilon_r$ is the permittivity of the delay line.

**5.** The device according to one of claims 2 to 4, **characterized in that** the delay line (22) comprises, at the output of the delay line, an amplifier (28) able to compensate for a power loss caused by said delay line (26).

**6.** The device according to one of claims 1 to 5, **characterized in that** the switch-triggering device (20) comprises a power measurer (30) and a level comparator (32), said comparator being able to compare an output level of said measurer (30) to a level threshold.

**7.** The device according to claim 6, **characterized in that** the level threshold is provided by an external device (34).

**8.** The device according to claim 6 or 7, **characterized in that** it includes a first output (12) and a second output (14), and **in that** the switch-triggering device (20) is able to command, based on the comparison done by the comparator (32) of the output level of the measurer (30) compared to the level threshold, the position of the switch (36) between a first position making it possible to convey the electromagnetic signal output by the delay module toward said first output (12) and a second position making it possible to convey the electromagnetic signal output by the delay module toward said second output (14).

9. The device according to any one of the preceding claims, **characterized in that** it is able to provide said at least one active component with a microwave electromagnetic signal having a frequency comprised between 0.1 GHz and 40 GHz.

10. An electronic system for amplifying microwave electromagnetic signals including a microwave electromagnetic signal transmitter (4), an amplification system (6) connected at the output of the transmitter (4) and a module (8) with active components connected at the output of the amplification system (6), **characterized in that** it includes a protection device (10) according to one of claims 1 to 9 connected in series between the amplification system (6) and the module (8) with active components.

FIG.1

FIG.2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5479119 A